(19) **Europäisches Patentamt / European Patent Office / Office européen des brevets**

(11) **EP 1 440 323 B1**

(12) **EUROPÄISCHE PATENTSCHRIFT**

(45) Veröffentlichungstag und Bekanntmachung des Hinweises auf die Patenterteilung:
**11.06.2008   Patentblatt 2008/24**

(21) Anmeldenummer: **02802272.1**

(22) Anmeldetag: **30.10.2002**

(51) Int Cl.:
*G01R 31/11* ^(2006.01)

(86) Internationale Anmeldenummer:
**PCT/DE2002/004042**

(87) Internationale Veröffentlichungsnummer:
**WO 2003/038455 (08.05.2003 Gazette 2003/19)**

(54) **VERFAHREN UND VORRICHTUNG ZUR PHASENBERECHNUNG AUS DEN DÄMPFUNGSWERTEN MITTELS HILBERTTRANSFORMATION BEI FDR-MESSUNGEN**

METHOD AND DEVICE FOR PHASE CALCULATION FROM ATTENUATION VALUES USING A HILBERT TRANSFORM FOR REFLECTOMETRIC MEASUREMENTS IN THE FREQUENCY DOMAIN

PROCEDE ET DISPOSITIF POUR LE CALCUL DE PHASE A PARTIR DES VALEURS D'ATTENUATION AU MOYEN D'UNE TRANSFORMEE DE HILBERT POUR DES MESURES PAR REFLECTOMETRIE DANS LE DOMAINE DES FREQUENCES

(84) Benannte Vertragsstaaten:
**AT BE BG CH CY CZ DE DK EE ES FI FR GB GR IE IT LI LU MC NL PT SE SK TR**

(30) Priorität: **30.10.2001   DE 10153090**
**13.12.2001   DE 10161399**

(43) Veröffentlichungstag der Anmeldung:
**28.07.2004   Patentblatt 2004/31**

(73) Patentinhaber: **T-Mobile Deutschland GmbH**
**53227 Bonn (DE)**

(72) Erfinder:
• **NOWOK, Gregor**
**90455 Nürnberg (DE)**
• **POSPIECH, Peter**
**91330 Eggolsheim (DE)**

(74) Vertreter: **Riebling, Peter**
**Patentanwalt,**
**Postfach 31 60**
**88113 Lindau/B. (DE)**

(56) Entgegenhaltungen:
**US-A- 5 482 044       US-A- 5 990 687**
**US-A- 5 994 905**

**Beschreibung**

Die Erfindung betrifft das Gebiet der sogenannten FDR-Messung (Frequency Domain Reflectometry) und bezieht sich insbesondere auf ein Verfahren und eine Vorrichtung zur Phasenberechnung aus den Dämpfungswerten mittels Hilberttransformation bei FDR-Messungen nach dem Oberbegriff der unabhängigen Patentansprüche.

FDR-Messungen werden z.B. in US 5994905, US 5990687 und US 5482044 beschrieben.

FDR-Messungen werden mit Hilfe von Netzwerkanalysatoren, die den Reflexionsfaktor nach Betrag und Phase bestimmen können, oder durch Spektrumanalysatoren, die nur den Betrag des Reflexionsfaktors messen können, vorgenommen. Bei den zur Zeit gängigen Messverfahren mit Hilfe von Spektrumanalysatoren mit Trackinggenerator wird die Berechnung der Phase durch Hilberttransformation vorgenommen. Wichtig für die numerische Qualität der Hilberttransformation ist die Tatsache, dass sich alle Polstellen der logarithmierten Dämpfungsfunktion möglichst weit links der imaginären Achse im Pol-Nullstellen-Diagramm befinden. Bei den zur Zeit existierenden Messsystemen wird dies durch eine vollsymmetrische Parallelverzweigung in der Messschaltung realisiert, die durch den Einsatz eines Koppelgliedes (Koppler) realisiert wird. Derartige Koppler haben allerdings einen sehr hohen Eigenreflexionsfaktor zum Messobjekt und eine geringe Einfügedämpfung von der Quelle zum Messobjekt und wieder zurück vom Messobjekt zum Leistungsmesser. Diese Schaltung gewährleistet nur die Vorrausetzungen zur Durchführung der Hilberttransformation, das heißt alle Pole der Dämpfungsfunktion liegen in der linken komplexen Halbebene. Dennoch treten in der Regel unerwünschte und relativ große Fehler bei der Berechnung der Phase auf.

Die Aufgabe der Erfindung liegt darin, ein Verfahren aufzuzeigen, mittels dem eine Genauigkeitssteigerung der Phasenberechnung aus den Dämpfungswerten mittels Hilberttransformation erreicht wird. Eine Vorrichtung zur Durchführung des Verfahrens soll ebenfalls angegeben werden.

Die Aufgabe wird erfindungsgemäß durch die in den unabhängigen Patentansprüchen angegeben Merkmale gelöst.

Vorteilhafte Ausgestaltungen und Weiterbildungen der Erfindung sind Gegenstand der abhängigen Patentansprüche.

Erfindungsgemäß wird der Koppler so gestaltet, dass er eine hohe Einfügedämpfung zwischen Quelle und Messobjekt und zwischen Messobjekt und Senke aufweist. Dadurch werden die Pole der Dämpfungsfunktion weiter in die linke komplexe Halbebene des Pol-Nullstellen-Diagramms verschoben, was eine qualitativ bessere Phasenberechnung nach sich zieht. Dieselbe Wirkung wird erzielt, indem ein Dämpfungsglied zwischen Koppler und Messobjekt eingefügt wird.

Im folgenden wir ein Ausführungsbeispiel der Erfindung anhand der Zeichnungen beschrieben. Aus den Zeichnungen und ihrer Beschreibung ergeben sich weitere Merkmale, Vorteile und Anwendungsgebiete der Erfindung.

Es zeigen:

Figur 1:   das Blockschaltbild der erfindungsgemäßen Messanordnung;
Figur 2:   Darstellung eines gemessenen Phasenverlaufs ohne Dämpfungsglied;
Figur 3:   Darstellung eines berechneten Phasenverlaufs ohne Dämpfungsglied;
Figur 4:   Darstellung des absoluten Phasenfehlers über der Frequenz ohne Dämpfungsglied;
Figur 5:   Darstellung eines gemessenen Phasenverlaufs mit Dämpfungsglied;
Figur 6:   Darstellung eines berechneten Phasenverlaufs mit Dämpfungsglied;
Figur 7:   Darstellung des absoluten Phasenfehlers über der Frequenz mit Dämpfungsglied.

Zunächst wird die Systemfunktion für die Beschaltung des Messsystems mit dem Dämpfungsglied angegeben. Danach wird auf den Fall ohne Dämpfungsglied spezialisiert und für beide Fälle die entsprechende Phase (Hilberttransformierte der Dämpfung) und deren Abweichungen zur Originalphase angegeben.

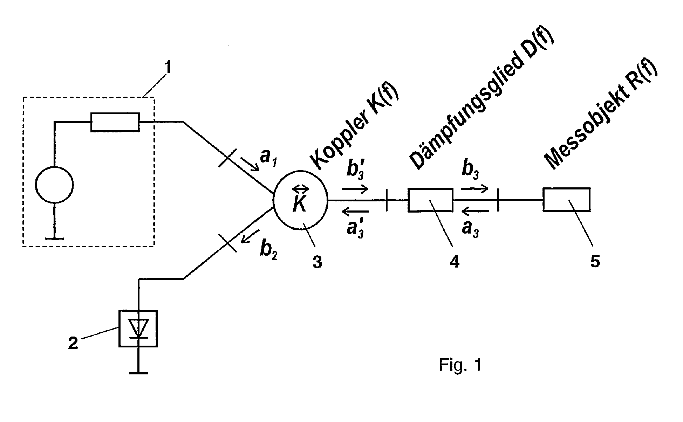

Figur 1 zeigt das Blockschaltbild der Messanordnung. Von einer Signalquelle 1, wird ein Messsignal über einen Koppler 3 und ein Dämpfungsglied 4 zu einem Messobjekt 5 gesendet. Der im Messobjekt reflektierte Anteil des Messsignals wird im Koppler 3 ausgekoppelt und zur Senke 2 (Empfänger) geführt. Gemessen wird die auf den Empfänger 2 zulaufende, also vom Messobjekt 5 reflektierte Leistungswelle $b_2$. Die zugehörige Systemfunktion für die Beschaltung mit dem Dämpfungsglied 4 am Tor 3 lautet:

$$b_2 = \left[ K_{21} + \frac{K_{23} \cdot K_{31} \cdot (D_{11} + \frac{D_{12} \cdot D_{21} \cdot R}{1 - D_{22} \cdot R})}{1 - K_{33} \cdot (D_{11} + \frac{D_{12} \cdot D_{21} \cdot R}{1 - D_{22} \cdot R})} \right] \cdot a_1 \quad ,$$

mit den folgenden Matrizen:

$$\bar{\bar{K}} = \begin{pmatrix} K_{11} & K_{12} & K_{13} \\ K_{21} & K_{22} & K_{23} \\ K_{31} & K_{32} & K_{33} \end{pmatrix} \quad \text{und} \quad \bar{D} = \begin{pmatrix} D_{11} & D_{12} \\ D_{21} & D_{22} \end{pmatrix}.$$

Wird das Dämpfungsglied 4 entfernt, so wird $D_{11} = D_{22} = 0$ und $D_{12} = D_{21} = 1$ und die obige Systemfunktion vereinfacht sich zu:

$$b_2 = \left[ K_{21} + \frac{K_{23} \cdot K_{31} \cdot R}{1 - K_{33} \cdot R} \right] \cdot a_1$$

R liegt jetzt am Tor 3'.

Die Berechnung der Phase aus dem Betrag der Leistungswerte erfolgt durch Hilberttransformation, die ihrerseits numerisch durch schnelle Faltung realisiert wird:

$$\Phi_2 = FFT \left\{ FFT^{-1} \left[ -1 \cdot \ln |b_2|(f) \right] \cdot \frac{1}{2} \cdot sign(t) \right\}$$

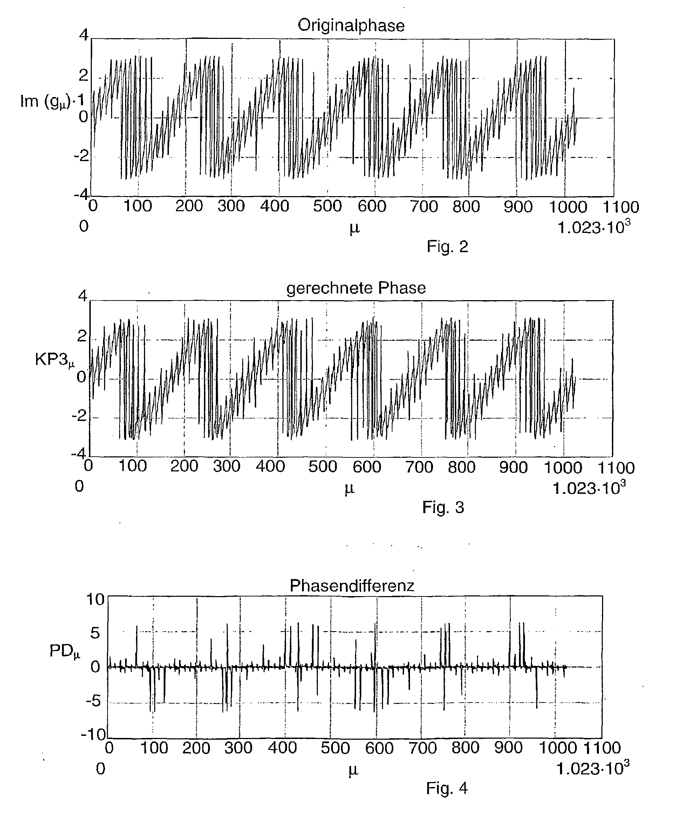

Die nachfolgenden Figuren 2 bis 4 zeigen die Unterschiede zwischen der gemessenen und berechneten Phase und die Fehlerfunktionen ohne Dämpfungsglied 4. Auf der Abszisse ist jeweils die Frequenz in MHz angegeben, während auf der Ordinate die Phase in rad aufgetragen ist.

Die Kurve gemäß Figur 2 ist die gemessene Originalphase, während die Kurve in Figur 3 die durch Hilberttransformation bestimmte Phase darstellt.

In Figur 4 ist zwischen den Figuren 2 und 3 bestimmte absolute Phasenfehler über der Frequenz dargestellt. Man erkennt deutlich, dass gerade im mittleren Frequenzbereich ein sehr großer Phasenfehler bei den berechneten Werten auftritt.

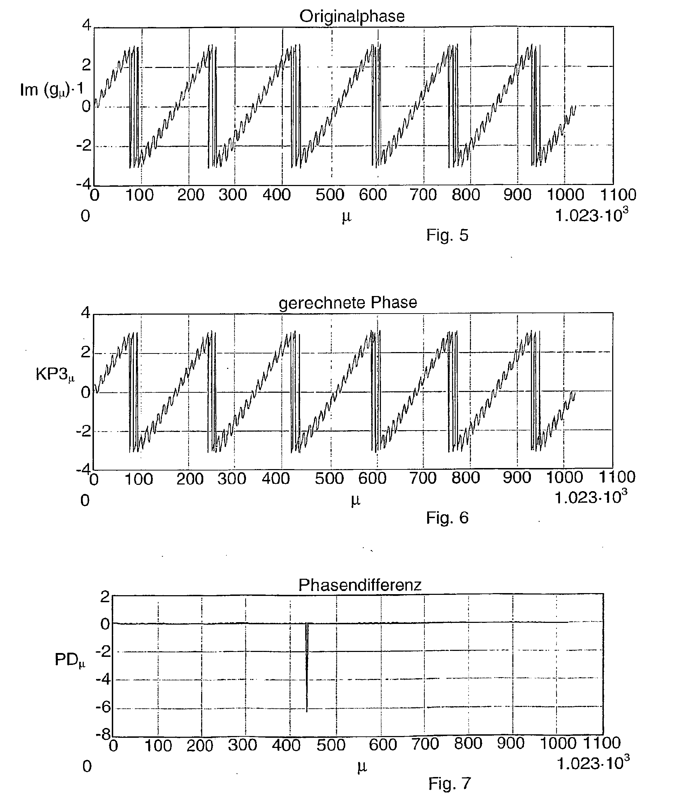

Die Figuren 5 bis 7 zeigen im Vergleich die Unterschiede von gemessener und berechneter Phase sowie die Fehlerfunktionen bei Einsatz eines Dämpfungsglieds 4 von -6 dB, das zwischen Koppler 3 und Messobjekt 5 geschaltet wurde. Der Eigenreflexionsfaktor D11 des Dämpfungsglieds 4 beträgt im gezeigten Beispiel 12%. Auch hier ist auf der Abszisse jeweils die Frequenz in MHz angegeben, während auf der Ordinate die Phase in rad aufgetragen ist.

Man erkennt, dass die Phasenkurven der Figuren 5 und 6 nahezu identisch sind, und praktisch kein Phasenfehler auftritt, was auf den Einfluss der zusätzlichen Dämpfung zurückzuführen ist.

In Figur 7 ist wieder der absolute Phasenfehler über der Frequenz aufgetragen. Aus der Darstellung ist zu erkennen, dass nur in der Mitte des Datensatzes ein Phasenfehler auftritt, dagegen wird beim Messsystem ohne Dämpfungsglied 4 gemäß den Figuren 2 bis 4 die Phase über den gesamten Bereich falsch berechnet.

**EP 1 440 323 B1**

**Patentansprüche**

1. Verfahren zur Phasenberechnung aus den Dämpfungswerten mittels Hilberttransformation bei FDR-Messungen, bei dem ein Messsignal über ein Kopplungsglied (3) auf ein Messobjekt (5) geführt wird und der vom Messobjekt reflektierte Anteil am Kopplungsglied (3) ausgekoppelt und gemessen wird, **dadurch gekennzeichnet, dass** zwischen dem Kopplungsglied (3) und dem Messobjekt (5) ein Dämpfungsglied (4) in den Signalpfad geschaltet wird.

2. Verfahren nach Anspruch 1, **dadurch gekennzeichnet, dass** der Koppler selbst als Dämpfungsglied wirkt.

3. Vorrichtung zur Phasenberechnung aus den Dämpfungswerten mittels Hilberttransformation bei FDR-Messungen, mit einer Signalquelle (1) für ein Messsignal, einem mit der Signalquelle (1) verbundenen Kopplungsglied (3) und einem mit dem Kopplungsglied (3) verbundenen Messobjekt, wobei das Messsignal über das Kopplungsglied (3) auf das Messobjekt (5) geführt wird und der vom Messobjekt (5) reflektierte Anteil des Messsignals über das Kopplungsglied (3) ausgekoppelt und an einer Senke (2) gemessen wird, **dadurch gekennzeichnet, dass** zwischen dem Kopplungsglied (3) und dem Messobjekt (5) ein Dämpfungsglied (4) in den Signalpfad geschaltet ist.

4. Vorrichtung nach Anspruch 3, **dadurch gekennzeichnet, dass** das Dämpfungsglied im Kopplungsglied enthalten ist.

**Claims**

1. Method for phase calculation from the attenuation values using a Hilbert transform in FDR measurements, in which a measurement signal is conducted via a coupling element (3) to an object (5) to be measured and the portion reflected by the object to be measured is uncoupled at the coupling element (3) and measured, **characterised in that** between the coupling element (3) and the object (5) to be measured an attenuator (4) is inserted in the signal path.

2. Method according to claim 1, **characterised in that** the coupler itself acts as an attenuator.

3. Device for phase calculation from the attenuation values using a Hilbert transform in FDR measurements, having a signal source (1) for a measurement signal, a coupling element (3) connected to the signal source (1), and an object (5) to be measured which is connected to the coupling element (3), the measurement signal being conducted via the coupling element (3) to the object (5) to be measured, and the portion of the measurement signal reflected by the object (5) to be measured being uncoupled via the coupling element (3) and measured at a sink (2), **characterised in that** between the coupling element (3) and the object (5) to be measured an attenuator (4) is inserted in the signal path.

4. Device according to claim 3, **characterised in that** the attenuator is contained in the coupling element.

**Revendications**

1. Procédé pour le calcul de phase à partir des valeurs d'atténuation à l'aide d'une transformée de Hilbert pour des mesures par réflectométrie dans le domaine fréquentiel, selon lequel un signal de mesure est amené par l'intermédiaire d'un élément de couplage (3) sur un objet de mesure (5), et la part qui est réfléchie par celui-ci est découplée et mesurée au niveau de l'élément de couplage (3), **caractérisé en ce qu'**un atténuateur (4) est monté dans la trajectoire du signal, entre l'élément de couplage (3) et l'objet de mesure (5).

2. Procédé selon la revendication 1, **caractérisé en ce que** le coupleur agit lui-même comme atténuateur.

3. Dispositif pour le calcul de phase à partir des valeurs d'atténuation à l'aide d'une transformée de Hilbert pour des mesures par réflectométrie dans le domaine fréquentiel, comportant une source de signaux (1) pour un signal de mesure, un élément de couplage (3) relié à la source de signaux (1), et un objet de mesure relié à l'élément de couplage (3), le signal de mesure étant amené par l'intermédiaire de l'élément de couplage (3) sur l'objet de mesure (5) et la part du signal de mesure qui est réfléchie par l'objet de mesure (5) étant découplée par l'intermédiaire de l'élément de couplage (3) et mesurée au niveau d'un drain (2), **caractérisé en ce qu'**un atténuateur (4) est monté dans la trajectoire du signal, entre l'élément de couplage (3) et l'objet de mesure (5).

4. Dispositif selon la revendication 3, **caractérisé en ce que** l'atténuateur est contenu dans l'élément de couplage.

Fig. 1

Originalphase

Fig. 2

gerechnete Phase

Fig. 3

Phasendifferenz

Fig. 4

## Originalphase

Fig. 5

## gerechnete Phase

Fig. 6

## Phasendifferenz

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5994905 A
- US 5990687 A
- US 5482044 A